(19) Europäisches Patentamt
European Patent Office
Office européen des brevets

(11) EP 1 195 909 A1

(12) **EUROPEAN PATENT APPLICATION**
published in accordance with Art. 158(3) EPC

(43) Date of publication:
**10.04.2002 Bulletin 2002/15**

(21) Application number: **01912275.3**

(22) Date of filing: **12.03.2001**

(51) Int Cl.[7]: **H03M 13/25**, H03M 13/27, H03M 13/45, H04J 11/00, H04L 27/00

(86) International application number:
**PCT/JP01/01919**

(87) International publication number:
**WO 01/84721 (08.11.2001 Gazette 2001/45)**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **01.05.2000 JP 2000132753**

(71) Applicant: **MITSUBISHI DENKI KABUSHIKI KAISHA**
**Tokyo 100-8310 (JP)**

(72) Inventors:
- **MIYATA, Yoshikuni, c/o MITSUBISHI DENKI K.K.**
  **Tokyo 100-8310 (JP)**
- **FUJITA, Hachiro, c/o MITSUBISHI DENKI K.K.**
  **Tokyo 100-8310 (JP)**
- **NAKAMURA, Takahiko,**
  **c/o MITSUBISHI DENKI K.K.**
  **Tokyo 100-8310 (JP)**
- **YOSHIDA, Hideo, c/o MITSUBISHI DENKI K.K.**
  **Tokyo 100-8310 (JP)**

(74) Representative: **Pfenning, Meinig & Partner**
**Mozartstrasse 17**
**80336 München (DE)**

(54) **METHOD AND APPARATUS FOR DEMODULATION**

(57) A demodulation method includes: a coset estimation step for estimating a low-order information bit based on a log-likelihood ratio of the low-order information bit and estimating a parity bit based on a log-likelihood ratio of the parity bit, so as to estimate a coset based on the low-order information bit and the parity bit; and a high-order information bit estimation step for estimating a transmitted signal point based on the coset so as to estimate a high-order information bit based on the transmitted signal point.

FIG.5

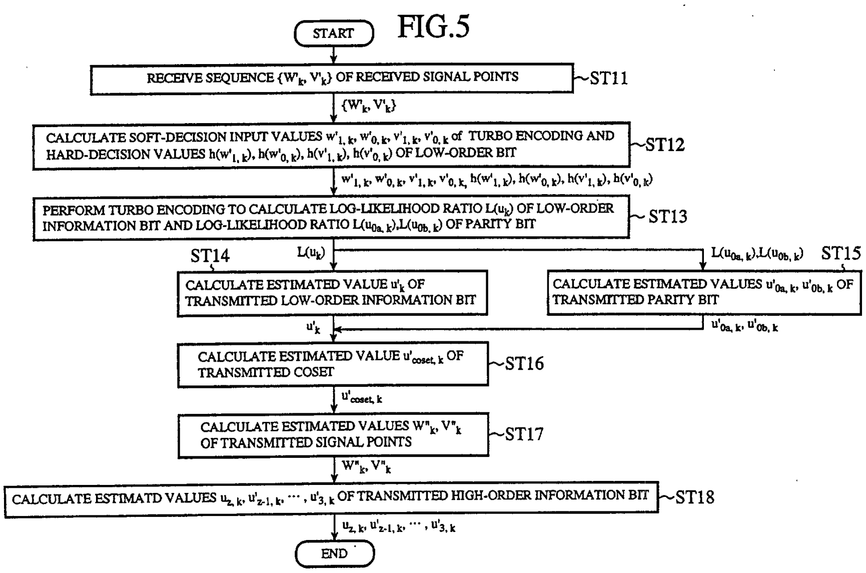


EP 1 195 909 A1

## Description

TECHNICAL FIELD

The present invention relates to a demodulating method and a demodulating apparatus according to the trellis coded modulation in which Turbo codes are used as element codes.

BACKGROUND ART

Fig. 1 is a flowchart showing a demodulating method according to the related art. Referring to Fig. 1, in a processing block ST1, a sequence $\{W'_k, V'_k\}$ of received signal constellation points $W'_k$, $V'_k$ (hereinafter, referred to as received signal points) is received. In ST2, soft-decision input values $w'_{1,k}$, $w'_{0,k}$, $v'_{1,k}$, $v'_{0,k}$, provided as Turbo decoding inputs, and low-order bit hard-decision values $h(w'_{1,k})$, $h(w'_{0,k})$, $h(v'_{1,k})$, $h(v'_{0,k})$ are calculated based on the sequence $\{W'_k, V'_k\}$ of the signal points. In ST3, Turbo decoding is performed using the soft-decision input values $w'_{1,k}$, $w'_{0,k}$, $v'_{1,k}$, $v'_{0,k}$, and the low-order bit hard-decision values $h(w'_{1,k})$, $h(w'_{0,k})$, $h(v'_{1,k})$, $h(v'_{0,k})$ so as to calculate the log-likelihood ratio $L(u_k)$ of the low-order information bit $u_k$. In ST4, an estimated value $u'_k$ of a transmitted low-order information bit is calculated based on the log-likelihood ratio $L(u_k)$ of the low-order information bit $u_k$. In ST5, hard-decision of a high-order information bit is performed based on the received signal points, so as to calculate estimated values $u'_{z,k}$, $u'_{z-1,k}$, ..., $u'_{3,k}$ of the transmitted high-order information bit.

Fig. 2(a) shows an encoder used in the trellis coded modulation method that uses Turbo codes as element codes. Fig. 2(b) is an encoder used in 16QAM (quadrature amplitude modulation). Fig. 2(c) shows a construction of a tone in a multi-carrier modulation and demodulation method. Referring to Figs. 2(a)-2(c), a Turbo encoder 1 receives an input of two information bits and outputs two information bits and 2 redundancy bits. A conversion 2 subjects a bit sequence output from the Turbo encoder to conversion. A mapper 3 converts the bit sequence converted by the conversion 2 into the signal points.

Fig. 3 shows a construction of the Turbo, encoder 1 of Figs. 2(a)-2(c) Referring to Fig. 3, the Turbo encoder 1 includes a recursive systematic convolutional encoder 11, interleavers 12 and 13, a recursive systematic convolutional encoder 14 and a deinterleaver 15.

A description will now be given of the operation of the Turbo encoder 1.

The Turbo encoder 1 receives the sequence $u_{2,1}$, $u_{2,2}$, ..., $u_{2,k}$, ..., $u_{2,N}$ of low-order information bits ($u_2$ sequence) and the sequence $u_{1,1}$, $u_{1,2}$, ..., $u_{1,k}$, ..., $u_{1,N}$ of the low-order information bit ($u_1$ sequence) in the chronological order (time 1, 2, ..., k, ..., N).

That is, the recursive systematic convolutional encoder 11 of the Turbo encoder 1 sequentially receives the $u_2$ sequence of low-order information bits and the $u_1$ sequence of low-order information bits for encoding and outputs a sequence $u_{0a,1}$, $u_{0a,2}$, $u_{0a,3}$, ..., $u_{0a,k}$, ..., $u_{0a,N}$ of parity bits ($u_{0a}$ sequence).

The recursive systematic convolutional encoder 14 of the Turbo encoder 1 sequentially receives for encoding the $u_2$ sequence of low-order information bits and the $u_1$ sequence of low-order information bits interleaved by the interleaver 12 and outputs a sequence $U_{0b,1}$, $u_{0b,2}$, $u_{0b,3}$, ..., $u_{0b,k}$, ..., $u_{0b,N}$ of parity bits ($u_{0b}$ sequence).

The $u_{0b}$ sequence of parity bits output from the recursive systematic convolutional encoder 14 is synchronized by the deinterleaver 15 to the original time.

The conversion 2 receives the $u_1$ low-order bit sequence, the $u_2$ low-order bit sequence, the $u_{0a}$ parity-bit sequence and the $u_{0b}$ parity-bit sequence so as to perform the following operation so that a receiver provides a uniform error correction performance on transmitted data.

$$\begin{cases} w_{1,k} = u_{2,k} + u_{1,k} + u_{0a,k} + u_{0b,k} \\ w_{0,k} = u_{2,k} + u_{1,k} \\ v_{1,k} = u_{2,k} + u_{0a,k} \\ v_{0,k} = u_{2,k} \end{cases} \qquad (1)$$

Where w and v each corresponds to a tone shown in Fig. 2(c).

Figs. 4(a)-4(c) shows constellations of signal points that occur in various digital modulation techniques. Fig. 4(a) shows a constellation of signal points in 4PSK (phase shift keying), Fig. 4(b) shows a constellation of signal points in 16QAM, and Fig. 4(c) shows a constellation of signal points in 64QAM. Referring to Figs. 4(a)-4(c), symbols A, B, C and D denote cosets, which are determined after the conversion.

The low-order information bits $u_1$ and $u_2$ and the parity bits $u_{0a}$ and $u_{0b}$ are used to determine $w_1$, $w_0$, $v_1$, $v_0$. The coset is determined by ($w_1$, $w_0$) or ($v_1$, $v_0$), as shown in Fig. 4(d).

Designation of four mutually adjacent signal points to be transmitted is based on the selection of coset.

When the coset is determined, the mapper 3 receives the coset and the high-order information bit so as to determine the transmitted signal point W or the transmitted signal point V based on the constellation of Figs. 4(a)-4(c).

On the receiving side, the received signal point W' or the received signal point V' is subject to hard-decision so as to estimate a sequence of most likely information bits (transmitted data).

That is, the signal point with a minimum distance from the received signal point is determined to be transmitted data. For the received signal point W' or the received signal point V', the four points closest to the received signal point constitute cosets A, B, C and D, respectively, in any of Figs. 4(a), 4 (b) and 4(c).

The four signal points with minimum point-to-point distance are likely to suffer from deterioration in the reception. Accordingly, in the related art, the low-order two bits for determination of the four immediately adjacent signal points are subject to the Turbo coding capable of excellent error correction. The decoder performs soft-decision according to the Turbo decoding so as to estimate the transmitted low-order information bit.

In contrast, signal points other than the four immediately adjacent signal points suffer a relatively serious deterioration in the reception. The high-order information bits for identification of these signal points (for example, the high-order information bit sequence u6, u5, u4, u3 of Fig. 2(c) are therefore subject to hard-decision by the decoder so as to estimate transmitted high-order information bit (i.e. determine ($w_3$, $w_2$), ($v_3$, $v_2$)).

A specific description will now be given of the demodulation method according to the related art.

In step ST1, the sequence $\{W'_k, V'_k\}$ of the received signal points $W'_k$, $V'_k$ is received, where k indicates time maintained in the Turbo encoder.

In step ST2, the soft-decision values $w'_{1,k}$, $w'_{0,k}$, $v'_{1,k}$, $v'_{0,k}$, provided as Turbo decoding inputs, and the low-order bit hard-decision values $h(w'_{1,k})$, $h(w'_{0,k})$, $h(v'_{1,k})$, $h(v'_{0,k})$ are calculated based on the sequence $\{W'_k, V'_k\}$ of the signal points. Hard-decision of the low-order bit is performed by determining the coset closest to the received signal point. Referring, for example, to Fig. 8(b), the coset B is closest to the received signal point 26 so that the low-order bits resulting from hard-decision are $h(w'_{1,k})=0$, $h(w'_{0,k})=1$ (Fig. 8(d)).

We focus on the transmitted signal point 25 and the received signal point 26 of Fig. 8(b). The transmitted signal point 25 is assumed to be located at (X,Y) in the X-Y coordinate of the W signal state space and the received signal point 26 is assumed to be located at (X',Y') in the X-Y coordinate of the W' signal state space.

A square Euclidean distance 27 between the transmitted signal point 25 and the received signal point 26 is calculated as follows.

$$d^2(W', W)=(X'-X)^2+(Y'-Y)^2 \qquad (2)$$

In step ST3, Turbo decoding is performed using the soft-decision input values $w'_{1,k}$, $w'_{0,k}$, $v'_{1,k}$, $v'_{0,k}$, and the low-order bit hard-decision values $h(w'_{1,k})$, $h(w'_{0,k})$, $h(v'_{1,k})$, $h(v'_{0,k})$ so as to calculate the log-likelihood ratio $L(u_k)$ of the low-order information bit $u_k$

In ST4, an estimated value $u'_k$ of a transmitted low-order information bit is calculated based on the log-likelihood ratio $L(u_k)$ of the low-order information bit $u_k$ calculated in step ST3.

In ST5, hard-decision of the high-order information bit is performed based on the received signal point 26 so as to calculate estimated values $u'_{z,k}$, $u'_{z-1,k}$, ..., $u'_{3,k}$ of the transmitted high-order information bit.

With the above-described arrangement of the related-art demodulating method, the transmitted low-order information bit is accurately estimated. However, since the transmitted high-order information bit is estimated by hard-decision based on the received signal point 26, the transmitted high-order information bit may incur improper error correction.

For example, assuming that, in response to a transmitted signal point 20, the signal point 21 is received as shown in Fig. 8(a). Since the hard-decision is performed in blocks defined by solid lines in Fig. 8(a), a high-order information bit determination area 24 may be used as an area for determination when a high-order information bit determination area 23 should actually be used, resulting in improper error correction of the transmitted high-order information bit.

The present invention has been developed in order to resolve the problems described above and has an object of providing a demodulating method and a demodulating apparatus in which the high-order information bit is accurately estimated so that the probability of error in decoding the high-order information bit is reduced.

DISCLOSURE OF THE INVENTION

The aforementioned objects can be achieved by a demodulation method comprising: a log-likelihood ratio calculation step for calculating soft-decision input values of Turbo decoding upon receipt of a sequence of received signal points, performing Turbo decoding using the soft-decision input values, and calculating a log-likelihood ratio of a low-order information bit and a log-likelihood ratio of a parity bit; a coset estimation step for estimating the low-order information bit based on the log-likelihood ratio of the low-order information bit calculated by the log-likelihood ratio calculation step, estimating the parity bit based on the log-likelihood ratio of the parity bit calculated by the log-likelihood ratio calculation step, so as to estimate a coset based on the low-order information bit and the parity bit; and high-order information bit estimation step for estimating a transmitted signal point based on the coset estimated by the coset estimation step, so as to estimate the high-order information bit based on the transmitted signal point.
Accordingly, it is possible to estimate the high-order information bit accurately so that the probability of errors in decoding the high-order information bit is reduced.
The log-likelihood ratio calculation step may calculate an Euclidean distance from a threshold value of a signal point constellation in a signal state space and use the calculated distance as soft-decision input values of the Turbo decoding.
With this, the soft-decision input values of Turbo decoding can be obtained in a relatively simple manner.
The log-likelihood ratio calculation step may perform the Turbo decoding for calculating a branch metric of trellis using a linear sum of the soft-decision input values, so as to calculate the log-likelihood ratio of the low-order information bit and the log-likelihood ratio of the parity bit.
With this, the process of calculation can be simplified.
The log-likelihood ratio calculation step may perform the Turbo decoding that includes conversion.
With this, the probability of errors in decoding the high-order information bit can be reduced when the conversion is included.
The log-likelihood ratio calculation step may calculate an Euclidean distance from a threshold value of a signal point constellation in a signal state space so as to use the calculated distance as the soft-decision input values of the Turbo decoding that includes conversion, perform the Turbo decoding whereby a branch metric of trellis is calculated using a linear sum of the soft-decision input values, so as to calculate the log-likelihood ratio of the low-order information bit and the log-likelihood ratio of the parity bit.
With this, the high-order information bit can be accurately estimated so that the probability of errors in decoding the high-order information bit is reduced.
The aforementioned objects can also be achieved by demodulation apparatus comprising: log-likelihood ratio calculation means for calculating soft-decision input values of Turbo decoding upon receipt of a sequence of received signal points, performs Turbo decoding using the soft-decision input values, and calculating a log-likelihood ratio of a low-order information bit and a log-likelihood ratio of a parity bit; a coset estimation means for estimating the low-order information bit based on the log-likelihood ratio of the low-order information bit calculated by the log-likelihood ratio calculation means, estimating the parity bit based on the log-likelihood ratio of the parity bit calculated by the log-likelihood ratio calculation means, so as to estimate a coset based on the low-order information bit and the parity bit; and high-order information bit estimation means for estimating a transmitted signal point based on the coset estimated by the coset estimation means so as to estimate a high-order information bit based on the transmitted signal point.
The log-likelihood ratio calculation means may calculate an Euclidean distance from a threshold value of a signal point constellation in a signal state space and use the calculated distance as soft-decision input values of the Turbo decoding.
With this, the soft-decision input values of the Turbo decoding can be obtained in a relatively simple manner.
The log-likelihood ratio calculation means may perform the Turbo decoding for calculating a branch metric of trellis using a linear sum of the soft-decision input values, so as to calculate the log-likelihood ratio of the low-order information bit and the log-likelihood ratio of the parity bit.
With this, the process of calculation can be simplified.
The log-likelihood ratio calculation means may perform the Turbo decoding that includes conversion.
With this, the probability of errors in decoding the high-order information bit is reduced when the conversion is included.
The log-likelihood ratio calculation means may calculate an Euclidean distance from a threshold value of a signal point constellation in a signal state space so as to use the calculated distance as the soft-decision input values of the Turbo decoding that includes conversion, perform the Turbo decoding whereby a branch metric of trellis is calculated using a linear sum of the soft-decision input values, so as to calculate the log-likelihood ratio of the low-order information bit and the log-likelihood ratio of the parity bit.
With this, the probability of errors in decoding the high-order information bit is reduced when the conversion is included.

BRIEF DESCRIPTION OF THE DRAWINGS

Fig. 1 is a flowchart showing a demodulating method according to the related art;
Fig. 2(a) shows an encoder used in the trellis coded modulation method that uses Turbo codes as element codes;
Fig. 2(b) is an encoder used in 16QAM;
Fig. 2(c) shows a construction of a tone in a multi-carrier modulation and demodulation method;
Fig. 3 shows a construction of the Turbo encoder of Figs. (2a)-2(c);
Fig. 4 (a) shows a constellation of signal points in 4PSK;
Fig. 4 (b) shows a constellation of signal points in 16QAM;
Fig. 4 (c) shows a constellation of signal points in 64QAM;
Fig. 4 (d) shows a table referred to in order to determine cosets;
Fig. 4(e) shows a table for use in 16QAM of Fig. 4B to determine one of areas E, F, G and H of the transmitted signal point responsive to the transmitted high-order information bit $w_3$, $w_2$ (or $v_3$, $v_2$);
Fig. 5 is a flowchart showing a demodulating method according to a first embodiment of the present invention;
Fig. 6 is a graph showing the probability of decoding error when the decoding according to the invention is performed;
Fig. 7 shows a demodulating apparatus according to a second embodiment of the present invention; and
Fig. 8(a) shows a comparison between the related art and the present invention about the areas for determination of high-order information bit;
Fig. 8 (b) shows a square Euclidean distance form a nearest signal point;
Fig. 8(c) shows an Euclidean distance from a threshold value; and
Fig. 8 (d) shows tables referred to in order to determine cosets.

BEST MODE OF CARRYING OUT THE INVENTION

In the following, the best mode of carrying out the invention will be described with reference to the attached drawings. First embodiment

Fig. 5 is a flowchart showing a demodulating method according to a first embodiment of the present invention. Referring to Fig. 5, a sequence $\{W'_k, V'_k\}$ of the received signal points $W'_k$, $V'_k$ is received in step ST11. In ST12, soft-decision input values $w'_{1,k}$, $w'_{0,k}$, $v'_{1,k}$, $v'_{0,k}$, provided as Turbo decoding inputs, and low-order bit hard-decision values $h(w'_{1,k})$, $h(w'_{0,k})$, $h(v'_{1,k})$, $h(v'_{0,k})$ are calculated based on the sequence $\{W'_k, V'_k\}$ of the signal points. In ST13, Turbo decoding is performed using the soft-decision input values $w'_{1,k}$, $w'_{0,k}$, $v'_{1,k}$, $v'_{0,k}$, and the low-order bit hard-decision values $h(w'_{1,k})$, $h(w'_{0,k})$, $h(v'_{1,k})$, $h(v'_{0,k})$ so as to calculate the log-likelihood ratio $L(u_k)$ of the low-order information bit and the log-likelihood ratio $L(u_{0a,k})$, $L(u_{0b,k})$ of the parity bit. The reception ST11 and the calculation steps ST12 and ST13 constitute a log-likelihood ratio calculation step.

In step ST14, an estimated value $u'_k$ of the low-order information bit is calculated based on the log-likelihood ratio $L(u_k)$ of the low-order information bit. In step ST15, estimated values $u'_{0a,k}$, $u'_{0b,k}$ of the parity bit are calculated based on the log-likelihood ratio $L(u_{0a,k})$, $L(u_{0b,k})$ of the parity bit. In ST16, an estimated value $u'_{coset,k}$ of the coset is calculated based on the estimated value $u'_k$ of the low-order information bit and the estimated values $u'_{0a,k}$, $u'_{0b,k}$ of the parity bit. The estimated value calculation steps ST14-ST16 constitute a coset estimation step.

In step ST17, estimated values $W''_k$, $V''_k$ of the transmitted signal point are calculated based on the estimated value $u'_{coset,k}$ of the coset. In step ST18, estimated values $u'_{z,k}$, $u'_{z-1,k}$, ..., $u'_{3,k}$ of the high-order information bit are calculated based on the estimated values $W''_k$, $V''_k$ of the transmitted signal point. The estimated value calculation steps ST17 and ST18 constitute a high-order information bit estimation step.

A description will now be given of the operation according to the first embodiment.

It is assumed that the transmitted signal points $W_k$, $V_k$ obtained as a result of multivalue QAM are affected by noise. In step ST11, a sequence $\{W'_k, V'_k\}$ of the received signal points $W'_k$, $V'_k$ is received, where k denotes time maintained by the Turbo encoder.

In the subsequent step ST12, soft-decision input values $w'_{1,k}$, $w'_{0,k}$, $v'_{1,k}$, $v'_{0,k}$, provided as Turbo decoding inputs, and low-order bit hard-decision values $h(w'_{1,k})$, $h(w'_{0,k})$, $h(v'_{1,k})$, $h(v'_{0,k})$ are calculated based on the sequence $\{W'_k, V'_k\}$ of the signal points.

$$\begin{cases} w'_{1,k} = d'_{0,X,k} \\ w'_{0,k} = d'_{0,Y,k} \\ v'_{1,k} = d'_{1,X,k} \\ v'_{0,k} = d'_{1,Y,k} \end{cases} \quad (3)$$

where $d'_{0,x,k}$, $d'_{1,x,k}$ indicates a Euclidean distance 28 from a threshold value illustrated in Fig. 8(c), and $d'_{0,Y,k}$, $d'_{1,Y,k}$ indicates a Euclidean distance 29 from a threshold value shown in Fig. 8(c).

Subsequently, in step ST13, Turbo decoding is performed using the soft-decision input values $w'_{1,k}$, $w'_{0,k}$, $v'_{1,k}$, $v'_{0,k}$, and the low-order bit hard-decision values $h(w'_{1,k})$, $h(w'_{0,k})$, $h(v'_{1,k})$, $h(v'_{0,k})$ so as to the calculate the log-likelihood ratio $L(u_k)$ of the low-order information bit $u_k$. The low-order information bit $u_k$ indicates a pair $(u_{2,k}, u_{1,k})$ input to the Turbo encoder of Fig. 3.

More specifically, the log-likelihood ratio $L(u_k)$ of the low-order information bit is calculated as follows.

Given, for example, that $u_{2,k}=0$, $u_{1,k}=0$ (hereinafter, simply represented as $u_k=00$) are designated as reference information bits, the log-likelihood ratio $L(u_k=00)$ for the transmitted information bit of $u_k=00$ is calculated as follows upon receipt of the sequence $\{W'_k, V'_k\}$ of the received signal points $W'_k$, $V'_k$.

$$L(u_k{=}00){=}\ln\frac{\Pr(u_k = 00|\{W'_k,V'_k\})}{\Pr(u_k = 00|\{W'_k,V'_k\})} \quad (4)$$

In this case, the log-likelihood $L(u_k=00)=0$ because $u_k=00$ is used as reference information bit.

The likelihood $L(u_k=01)$ for the transmitted information bit $u_k=01$, the likelihood $L(u_k=10)$ for $u_k=10$, the likelihood $L(u_k=11)$ for $u_k=11$, upon receipt of the sequence $\{W'_k, V'_k\}$ of the received signal points $W'_k$, $V'_k$, are calculated as follows.

$$L(u_k{=}01){=}\ln\frac{\Pr(u_k = 01|\{W'_k,V'_k\})}{\Pr(u_k = 00|\{W'_k,V'_k\})} \quad (5)$$

$$L(u_k{=}10){=}\ln\frac{\Pr(u_k = 10|\{W'_k,V'_k\})}{\Pr(u_k = 00|\{W'_k,V'_k\})} \quad (6)$$

$$L(u_k{=}11){=}\ln\frac{\Pr(u_k = 11|\{W'_k,V'_k\})}{\Pr(u_k = 00|\{W'_k,V'_k\})} \quad (7)$$

where $\Pr(u_k=00|\{W'_k, V'_k\})$ indicates conditional probability for the transmitted information bit of $u_{2,k}=0$, $u_{1,k}=0$ when the sequence $\{W'_k, V'_k\}$ of the received signal points $W'_k$, $V'_k$ is received.

Similarly, $\Pr(u_k=01|\{W'_k, V'_k\})$ indicates conditional probability for the transmitted information bit of $u_{2,k}=0$, $u_{1,k}=1$ when the sequence $\{W'_k, V'_k\}$ of the received signal points $W'_k$, $V'_k$ is received; $\Pr(u_k=10|\{W'_k, V'_k\})$ indicates conditional probability for the transmitted information bit of $u_{2,k}=1$, $u_{1,k}=0$ when the sequence $\{W'_k, V'_k\}$ of the received signal points $W'_k$, $V'_k$ is received; and $\Pr(u_k=11|\{W'_k, V'_k\})$ indicates conditional probability for the transmitted information bit of $u_{2,k}=1$, $u_{1,k}=1$ when the sequence $\{W'_k, V'_k\}$ of the received signal points $W'_k$, $V'_k$ is received.

In step ST13, the log-likelihood $L(u_{0a,k})$, $L(u_{0b,k})$ of the parity bit is also calculated. Not only that the low-order information bit is subject to Turbo encoding but also that the parity bit generated as a result of Turbo encoding is included in the transmitted signal points.

More specifically, the log-likelihood ratio $L(u_{0a,k})$ for the parity bit $u_{0a,k}$ output from the recursive systematic convolutional encoder 11 of the Turbo encoder 1 and the log-likelihood ratio $L(u_{0b,k})$ for the parity bit $u_{0b,k}$ output from the recursive systematic convolutional encoder 14 are calculated as follows.

$$L(u_{0a,k})=\ln\frac{Pr(u_{0a,k}=1|\{W'_k,V'_k\})}{Pr(u_{0a,k}=0|\{W'_k,V'_k\})} \quad (8)$$

$$L(u_{0b,k})=\ln\frac{Pr(u_{0b,k}=1|\{W'_k,V'_k\})}{Pr(u_{0b,k}=0|\{W'_k,V'_k\})} \quad (9)$$

where $Pr(u_{0a,k}=0|\{W'_k, V'_k\})$ indicates conditional probability for the parity bit of $u_{0a,k}=0$ when the sequence $\{W'_k, V'_k\}$ of the received signal points $W'_k$, $V'_k$ is received; and $Pr(u_{0a,k}=1|\{W'_k, V'_k\})$ indicates conditional probability for the parity bit of $u_{0a,k}=1$ when the sequence $\{W'_k, V'_k\}$ of the received signal points $W'_k$, $V'_k$ is received

Similarly, $Pr(u_{0b,k}=0 | \{W'_k, V'_k\})$ indicates conditional probability for the parity bit of $u_{0b,k}=0$ when the sequence $\{W'_k, V'_k\}$ of the received signal points $W'_k$, $V'_k$ is received; and $Pr(u_{0b,k}=1|\{W'_k, V'_k\})$ indicates conditional probability for the parity bit of $u_{0b,k}=1$ when the sequence $\{W'_k, V'_k\}$ of the received signal points $W'_k$, $V'_k$ is received

In step ST14, an estimated value $u'_k$ of the low-order information bit $u_k$ is calculated based on the log-likelihood ratios $L(u_k=00)$, $L(u_k=01)$, $L(u_k=10)$, $L(u_k=11)$ of the low-order information bit.

More specifically, the information bit that corresponds to one of the log-likelihood ratios $L(u_k=00)$, $L(u_k=01)$, $L(u_k=10)$, $L(u_k=11)$, of the low-order information bit, that assumes the maximum value is designated as the estimated value $u'_k$ of the low-order information bit.

Step ST15 is performed concurrently with step ST14 so that the estimated values $u'_{0a,k}$, $u'_{0b,k}$ of the parity bit are calculated based on the log-likelihood ratio $L(u_{0a,k})$, $L(u_{0b,k})$ of the parity bit.

More specifically, when it is determined. that the log-likelihood ratio $L(u_{0a,k})>0$, the parity bit estimated value $u'_{0a,k}$ is determined to be "1". When $L(u_{0a,k})\leq 0$, the parity bit estimated value $u'_{0a,k}$ is determined to be "0".

Subsequently, in step ST16, an estimated value $u'_{coset,k}$ of the coset is calculated based on the estimated value $u'_k$ of the low-order information bit and the estimated values $u'_{0a,k}$, $u'_{0b,k}$ of the parity bit.

For example, when the conversion 2 of Figs. 2(a) and 2(b) provides the performance of equation (1), the following steps are performed so as to calculate $w''_{1,k}$, $w''_{0,k}$, $v''_{1,k}$, $v''_{0,k}$.

$$\begin{cases} w''_{1,k} = u'_{2,k} + u'_{1,k} + u'_{0a,k} + u'_{0b,k} \\ w''_{0,k} = u'_{2,k} + u'_{1,k} \\ v''_{1,k} = u'_{2,k} + u'_{0a,k} \\ v''_{0,k} = u'_{2,k} \end{cases} \quad (10)$$

The table of Fig. 4(d) is referred to so as to determine the estimated value $u'_{coset,k}$ of the coset.

In step ST17, estimated values $W''_k$, $V''_k$ of the transmitted signal point are calculated based on the estimated value $u'_{coset,k}$ of the coset. The estimated values $u'_{coset,k}$ of the coset closest to the received signal points $W'_k$, $V'_k$ are designated as estimated values $W''_k$, $V''_k$ of the transmitted signal points.

Finally, in step ST18, estimated values $u'_{z,k}$, $u'_{z-1,k}$, ..., $u'_{3,k}$ of the high-order information bit are calculated based on the estimated values $W''_k$, $V''_k$ of the transmitted signal points.

As has been described, the first embodiment includes a coset estimation step for estimating the low-order information bit based on the log-likelihood of the low-order information bit and estimating the parity bit based on the log-likelihood ratio of the parity bit, so as to estimate the coset based on the low-order information bit and the parity bit. The first embodiment further includes a high-order information bit estimation step for estimating transmitted signal points based on the coset and estimating the high-order information bit based on the transmitted signal points. With this, the high-order information bit is accurately estimated so that the probability of error in decoding the high-order information bit is reduced.

One thing to be noted is that the volume of calculation is increased as a result of implementing the first embodiment. Extra steps for calculation required at the last stage of recursive decoding are the calculation of the log-likelihood ratio of the parity bit $L(u_{0a,k})$, $L(u_{0b,k})$ of the parity bit, calculation of the estimated values $u'_{0a,k}$, $u'_{0a,k}$ of the transmitted parity bit, and calculation of the estimated value $u'_{coset,k}$ of the transmitted coset. However, these steps of calculation are performed at the last cycle of recursion requiring only a small increase in the volume of calculation.

Fig. 6 is a graph showing decoding error probability occurring when the demodulation method of the first embodiment and that of the related art are performed. In Fig. 6, a ratio ($E_b/N_0$) between transmission power and noise power per information bit is plotted horizontally, and a bit error probability of the high-order information bit is plotted vertically.

The demodulation method according to the related art and that of the first embodiment are the same in that both provide same level of decoding error probability of the low-order information bit. However, as obviously shown in Fig. 6, the demodulating method according to the first embodiment is superior in that the decoding error probability of the high-order information bit is significantly reduced as compared to the related art.

The decoding error probability of the high-order information bit is significantly reduced for the following reasons.

It is assumed that the signal point 20 (Fig. 8(a)) is transmitted, the signal point 21 is received and the low-order information bit is accurately estimated as a result of Turbo encoding. As already described, according to the related art, hard decision is performed in areas indicated by solid lines in Fig. 8(a). Therefore, the area 24 may be erroneously selected for determination of the high-order information bit, when actually the area 23 should be selected instead of the are 24, resulting in a correction error.

In contrast, according to the first embodiment, one of the points constituting a coset C which point is closest to the received signal point is determined to be the transmitted signal point. By determining that the point constituting the coset C which point is closest to the received signal point is the transmitted signal point 20, transmitted signal point 20 can be accurately recovered. Since the area 23 can properly be selected for determination of the high-order information bit, the high-order information bit can be accurately determined. Where the related-art may produce a correction error, the method according to the first embodiment could provide an accurate correction. Accordingly, the decoding error probability of the high-order information bit is successfully reduced.

Second embodiment

Fig. 7 shows a construction of a demodulating apparatus according to a second embodiment of the present invention. Referring to Fig. 7, the demodulating apparatus comprises a log-likelihood ratio calculation means 30, a soft-decision input value calculator 31 for calculating soft-decision input values $w'_{1,k}$, $w'_{0,k}$, $v'_{1,k}$, $v'_{0,k}$, provided as Turbo decoding inputs, and low-order bit hard-decision values $h(w'_{1,k})$, $h(w'_{0,k})$, $h(v'_{1,k})$, $h(v'_{0,k})$, based on the sequence $\{W'_k, V'_k\}$ of the signal points $W'_k$, $V'_k$. The demodulating apparatus further comprises a decoder 32 whereby Turbo decoding is performed using the soft-decision input values $w'_{1,k}$, $w'_{0,k}$, $v'_{1,k}$, $v'_{0,k}$, and the low-order bit hard-decision values $h(w'_{1,k})$, $h(w'_{0,k})$, $h(v'_{1,k})$, $h(v'_{0,k})$ so as to calculate the log-likelihood ratio $L(u_k)$ of the low-order information bit and the log-likelihood ratio $L(u_{0a,k})$ of the parity bit.

Numeral 33 indicates a received amplitude calculator for calculating a received amplitude value $L_{ch}(u_k)$, based on the soft-decision input values $w'_{1,k}$, $w'_{0,k}$, $v'_{1,k}$, $v'_{0,k}$, and the low-order bit hard-decision values $h(w'_{1,k})$, $h(w'_{0,k})$, $h(v'_{1,k})$, $h(v'_{0,k})$. Numeral 34 indicates a subtractor for subtracting the received amplitude value $L_{ch}(u_k)$ and a priori probability ratio $L_a(u_k)$ from the log-likelihood ratio $L(u_k)$ of the low-order information bit so as to output an extrinsic information probability ratio $L_e(u_k)$. Numeral 35 indicates an interleaver for interleaving the extrinsic information probability ratio $L_e(u_k)$ for synchronization with the recursive systematic convolutional encoder 14 and outputs a result of interleaving as a priori probability ratio $L_a(u_k)$. Numeral 36 indicates an interleaver for interleaving the soft-decision input values $w'_{1,k}$, $w'_{0,k}$, $v'_{1,k}$, $v'_{0,k}$, and the low-order bit hard-decision values $h(w'_{1,k})$, $h(w'_{0,k})$, $h(v'_{1,k})$, $h(v'_{0,k})$ for synchronization with the recursive systematic convolutional encoder 14. Numeral 37 indicates an interleaver for interleaving the received amplitude value $L_{ch}(u_k)$ for synchronization with the recursive systematic convolutional encoder 14.

Numeral 38 indicates a decoder whereby Turbo decoding is performed using the soft-decision input values $w'_{1,k}$, $w'_{0,k}$, $v'_{1,k}$, $v'_{0,k}$, and the low-order bit hard-decision values $h(w'_{1,k})$, $h(w'_{0,k})$, $h(v'_{1,k})$, $h(v'_{0,k})$ so as to calculate the log-likelihood ratio $L(u_k)$ of the low-order information bit and the log-likelihood ratio $L(u_{0b,k})$ of the parity bit generated by the recursive systematic convolutional encoder 14. Numeral 39 indicates a subtractor for subtracting the received amplitude value $L_{ch}(u_k)$ and a priori probability ratio $L_a(u_k)$ from the log-likelihood ratio $L(u_k)$ of the low-order information bit so as to output an extrinsic information probability ratio $L_e(u_k)$. Numeral 40 indicates an interleaver for interleaving the extrinsic information $L_e(u_k)$ for synchronization with the recursive systematic convolutional encoder 11 so as to output a result of interleaving as a priori probability ratio $L_a(u_k)$. Numeral 41 indicates a switch initially connected to side I and connected to side II at second and subsequent cycles for decoding.

Numeral 42 indicates a coset estimation means. Numeral 43 indicates a determination unit for determining the parity bit of the recursive systematic convolutional encoder 11, based on the log-likelihood ratio $L(u_{0a,k})$ of the parity bit calculated by the decoder 32 so as to calculate an estimated value $u'_{0a,k}$ of the original transmitted parity. Numeral 44 indicates a determination unit for determining the low-order information bit and the parity bit of the recursive systematic convolutional encoder 14, based on the log-likelihood ratio $L(u_k)$ of the low-order information bit and the log-likelihood ratio $L(u_{0a,k})$ of the parity bit calculated by the decoder 38 so as to calculate an estimated value $u'_k(=u'_{2,k}, u'_{1,k})$ of the original transmitted low-order information bit and an estimated value $u'_{0b,k}$ of the original transmitted parity. Numeral 45 indicates a determination unit for calculating an estimated value $u'_{coset,k}$ of the coset, based on the esti-

mated value $u'_k(=u'_{2,k}, u'_{1,k})$ of the original transmitted low-order information bit and the estimated values $u'_{0a,k}$ and $u'_{0b,k}$ of the original transmitted parity. Numeral 46 indicates a determination unit (high-order bit estimation means) for calculating estimated values $u'_{z,k}$, $u'_{z-1,k}$, ..., $u'_{3,k}$ of the high-order information bit, based on the received signal points $W'_k$ and $V'_k$ and the estimated value $u'_{coset,k}$ of the coset.

A description will now be given of the operation according to the second embodiment.

The soft-decision input value calculator. 31 receives the sequence $\{W'_k, V'_k\}$ of the signal points $W'_k$, $V'_k$ and determines the soft-decision input values $w'_{1,k}$, $w'_{0,k}$, $v'_{1,k}$, $v'_{0,k}$, provided as Turbo decoding inputs, and low-order bit hard-decision values $h(w'_{1,k})$, $h(w'_{0,k})$, $h(v'_{1,k})$, $h(v'_{0,k})$, by performing the calculation of equation (3).

When the soft-decision input value calculator 31 calculates the soft-decision input values $w'_{1,k}$, $w'_{0,k}$, $v'_{1,k}$, $v'_{0,k}$, provided as Turbo decoding inputs, and the low-order bit hard-decision values $h(w'_{1,k})$, $h(w'_{0,k})$, $h(v'_{1,k})$, $h(v'_{0,k})$, and when the switch, 41 outputs a priori probability ratio $L_a(u_k)$, the decoder 32 performs Turbo decoding on the soft-decision input values $w'_{1,k}$, $w'_{0,k}$, $v'_{1,k}$, $v'_{0,k}$, and the low-order bit hard-decision values $h(w'_{1,k})$, $h(w'_{0,k})$, $h(v'_{1,k})$, $h(v'_{0,k})$, so as to calculate the log-likelihood ratio $L(u_k)$ of the low-order information bit. Since the switch 41 is initially connected to side I, an initial value 0 is output to the decoder 32 at a first cycle of decoding. In the second and subsequent cycles of decoding, the switch 41 is connected to side II so that the a priori probability ratio $L_a(u_k)$ output from the deinterleaver 40 is output to the decoder 32.

More specifically, by performing calculations according to equations (4)-(7), the log-likelihood ratio $L(u_k)$ of the low-order information bit is determined.

When the soft-decision input value calculator 31 calculates the soft-decision input values $w'_{1,k}$, $w'_{0,k}$ $v'_{1,k}$, $v'_{0,k}$, provided as Turbo decoding inputs, and the low-order bit hard-decision values $h(w'_{1,k})$, $h(w'_{0,k})$, $h(v'_{1,k})$, $h(v'_{0,k})$ the received amplitude value calculator 33 calculates the received amplitude value $L_{ch}(u_k)$, based on the soft-decision input values $w'_{1,k}$, $w'_{0,k}$, $v'_{1,k}$, $v'_{0,k}$, provided as Turbo decoding inputs, and the low-order bit hard-decision values $h(w'_{1,k})$, $h(w'_{0,k})$, $h(v'_{1,k})$, $h(v'_{0,k})$. That is, by performing calculations according to the following equations (11)-(14), the received amplitude value $L_{ch}(u_k)$ is determined.

$$L_{ch}(u_k=00)\equiv\ln\frac{Pr(W'_k,V'_k|u_k = 00)}{Pr(W'_k,V'_k|u_k = 00)} \tag{11}$$

$$L_{ch}(u_k=01)\equiv\ln\frac{Pr(W'_k,V'_k|u_k = 01)}{Pr(W'_k,V'_k|u_k = 00)} \tag{12}$$

$$L_{ch}(u_k=10)\equiv\ln\frac{Pr(W'_k,V'_k|u_k = 10)}{Pr(W'_k,V'_k|u_k = 00)} \tag{13}$$

$$L_{ch}(u_k=11)\equiv\ln\frac{Pr(W'_k,V'_k|u_k = 11)}{Pr(W'_k,V'_k|u_k = 00)} \tag{14}$$

where $L_{ch}(u_k=00)=0$ because $u_k=00$ is designated as reference information bit.

The subtractor 34 subtracts the received amplitude value $L_{ch}(u_k)$ and a priori probability ratio $L_a(u_k)$ from the log-likelihood ratio $L(u_k)$ of the low-order information bit, so as to output the extrinsic information probability ratio $L_e(u_k)$. That is, by performing calculations according to the following equations (15)-(18), the extrinsic information probability ratio $L_e(u_k)$ is determined.

$$L_e(u_k=00)=L(u_k=00)-L_{ch}(u_k=00)$$
$$-L_a(u_k=00) \tag{15}$$

$$L_e(u_k=01)=L(u_k=01)-L_{ch}(u_k=01)$$
$$-L_a(u_k=01) \tag{16}$$

$$L_e(u_k=10)=L(u_k=10)-L_{ch}(u_k=10)$$

$$-L_a(u_k=10) \quad (17)$$

$$L_e(u_k=11) =L (u_k=11) -L_{ch}(u_k=11)$$

$$-L_a(u_k=11) \quad (18)$$

In the first cycle of decoding, an initial value

$$L_a(u_k=00)=L_a(u_k=01)=L_a(u_k=10)=L_a(u_k=11)=0$$

is input.

When the subtractor 34 outputs the extrinsic information probability ratio $L_e(u_k)$, the interleaver 35 interleaves the extrinsic information probability ratio $L_e(u_k)$ for synchronization with the recursive systematic convolutional encoder 14 so as to output the interleaved extrinsic information probability $L_e(u_k)$ as a priori probability ratio $L_a(u_k)$.

When the soft-decision input value calculator 31 outputs the soft-decision input values $w'_{1,k}$, $w'_{0,k}$, $v'_{1,k}$, $v'_{0,k}$, provided as Turbo decoding inputs, and the low-order bit hard-decision values $h(w'_{1,k})$, $h(w'_{0,k})$, $h(v'_{1,k})$, $h(v'_{0,k})$, the interleaver 36 interleaves the soft-decision input values $w'_{1,k}$, $w'_{0,k}$, $v'_{1,k}$, $v'_{0,k}$, and the low-order bit hard-decision values $h(w'_{1,k})$, $h(w'_{0,k})$, $h(v'_{1,k})$, $h(v'_{0,k})$ for synchronization with the recursive systematic convolutional encoder 14.

When the received amplitude calculator 33 outputs the received amplitude $L_{ch}(u_k)$, the interleaver 37 interleaves the received amplitude $L_{ch}(u_k)$ for synchronization with the recursive systematic convolutional encoder 14.

When the soft-decision input value calculator 31 outputs the soft-decision input values $w'_{1,k}$, $w'_{0,k}$, $v'_{1,k}$, $v'_{0,k}$, provided as Turbo decoding inputs, and the low-order bit hard-decision values $h(w'_{1,k})$, $h(w'_{0,k})$, $h(v'_{1,k})$, $h(v'_{0,k})$, and when the interleaver 35 outputs a priori probability ratio $L_a(u_k)$, the decoder 38, like the decoder 35, performs Turbo decoding on the soft-decision input values $w'_{1,k}$, $w_{0,k}$, $v'_{1,k}$, $v'_{0,k}$, and the low-order bit hard-decision values $h(w'_{1,k})$, $h(w'_{0,k})$, $h(v'_{1,k})$, $h(v'_{0,k})$, so as to calculate the log-likelihood ratio $L(u_k)$ of the low-order information bit.

More specifically, the log-likelihood ratio $L(u_k)$ of the low-order information bit is determined by performing calculations according to equations (4)-(7).

The subtractor 39 subtracts the received amplitude value $L_{ch}(u_k)$ and a priori probability ratio $L_a(u_k)$ from the log-likelihood ratio $L(u_k)$ of the low-order information bit so as to output an extrinsic information probability ratio $L_e(u_k)$. That is, like the subtractor 34, the subtractor 39 determines the extrinsic information probability ratio $L_e(u_k)$ by performing calculations according to equations (15)-(18).

When the subtractor 39 outputs the extrinsic information probability ratio $L_e(u_k)$, the deinterleaver 40 interleaves the extrinsic information probability ratio $L_e(u_k)$ for synchronization with the recursive systematic convolutional encoder 11. The deinterleaver 40 feeds back the extrinsic information probability ratio $L_e(u_k)$ as a priori probability ratio $L_a(u_k)$ to the decoder 32.

By performing the above steps a predetermined number of times, the log-likelihood ratio calculating means 30 is capable of calculating the log-likelihood ratio with improved precision.

In addition to the log-likelihood ratio $L(u_k)$ of the low-order information bit, the decoder 32 calculates the log-likelihood ratio $L(u_{0a,k})$ of the parity bit generated by the recursive systematic convolutional encoder 11 according to the equation (8), in the last cycle of repeating the steps.

Likewise, in addition to the log-likelihood ratio $L(u_k)$ of the low-order information bit, the decoder 38 calculates the log-likelihood ratio $L(u_{0b,k})$ of the parity bit generated by the recursive systematic convolutional encoder 14 according to the equation (9), in the last cycle of repeating the steps.

When the decoder 32 calculates the log-likelihood ratio $L(u_{0a,k})$, the determination unit 43 determines the parity bit of the recursive systematic convolutional encoder 11 based on the log-likelihood ratio $L(u_{0a,k})$ of the parity bit so as to calculate the estimated value $u'_{0a,k}$ of the transmitted parity bit.

More specifically, when the log-likelihood ratio $L(u_{0a,k})>0$, the assumed value $u'_{0a,k}$ of the parity bit is determined to be "1". When the log-likelihood ratio $L(u_{0a,k})\leq 0$, the assumed value $u'_{0a,k}$ of the parity bit is determined to be "0".

When the decoder 38 calculates the log-likelihood ratio $L(u_{0b,k})$, the determination unit 44 determines the parity bit of the recursive systematic convolutional encoder 14 based on the log-likelihood ratio $L(u_{0b,k})$ of the parity bit so as to calculate the estimated value $u'_{0b,k}$ of the transmitted parity bit.

More specifically, when the log-likelihood ratio $L(u_{0b,k}) >0$, the assumed value $u'_{0b,k}$ of the parity bit is determined to be "1". When the log-likelihood ratio $L(u_{0b,k}) \leq 0$, the assumed value $u'_{0b,k}$ of the parity bit is determined to be "0".

When the log-likelihood ratio $L(u_k)$ of the low-order information bit is output, the determination unit 44 calculates the estimated value $u'_k$ of the low-order information bit $u_k$ based on the log-likelihood ratio $L(u_k)$ of the low-order information bit.

That is, when a set of log-likelihood ratio $L(u_k=00)$, $L(u_k=01)$, $L(u_k=10)$, $L(u_k=11)$ is output, the information bit that corresponds to the maximum log-likelihood ratio is designated as the estimated value $u'_k$ of the low-order information bit $u_k$.

The determination unit 45 calculates the estimated value $u'_{coset,k}$ of the coset, based on the estimated value $u'_k(=u'_{2,k}, u'_{1,k})$ of the low-order information bit calculated by the determination unit 44 and the estimated value $u'_{0a,k}$, $u'_{0b,k}$ of the parity bit calculated by the determination units 43 and 44.

For example, when the conversion 2 of Fig. 2(a) and Fig. 2(b) is denoted by the equation (1), the calculation according to the equation (10) is performed so as to calculate $w''_{1,k}$, $w''_{0,k}$, $v''_{1,k}$, $v''_{0,k}$ and determine the estimated value $u'_{coset,k}$ of the coset by referring to the table of Fig. 4(d).

When the determination unit 45 calculates the estimated value $u'_{coset,k}$ of the coset, the determination unit 46 calculates the estimated value $W''_k$, $V''_k$ of the transmitted signal point, based on the received signal point $W'_k$, $V'_k$ and the estimated value $u'_{coset,k}$ of the coset. In the estimated value $u'_{coset,k}$ of the coset, the signal point closest to the received signal point $W'_k$, $V'_k$ is designated as the estimated value $W''_k$, $V''_k$ of the transmitted signal point.

The determination unit 46 calculates the estimated values $u'_{z,k}$, $u'_{z-1,k}$, ..., $u'_{3,k}$ of the high-order information bit based on the estimated value $W''_k$, $V''_k$ of the transmitted signal point.

Thus, the second embodiment provides an advantage in that the high-order information bit is accurately estimated so that the probability of errors in decoding the high-order information is reduced.

Third embodiment

In the second embodiment, the log-likelihood ratio calculating means 30 calculates the log-likelihood ratio of the low-order information bit and the log-likelihood ratio of the parity bit. Alternatively, Turbo decoding for calculating a branch metric of trellis using a linear sum of soft-decision input values, so as to calculate the log-likelihood ratio of the low-order information bit and the log-likelihood ratio of the parity bit.

The third embodiment provides improvement in the calculation of soft-decision input values by the soft-decision input value calculator 31 and the method of branch metric calculation.

In the related art, soft-decision input values are determined by calculating the square Euclidean distance 27 between the received signal point 26 and the transmitted signal point 25 (Fig. 8(b)). In the first and second embodiments, soft-decision input values are determined by calculating the Euclidean distances 28 and 29 between the received signal point 26 and the threshold value, as shown in Fig. 8(c).

The principle of Fig. 8(b) will now be described using a mathematical expression. It is assumed the transmitted signal point 25 is located at (X, Y) in the X-Y coordinate system of the signal state space for W, and the received signal point 26 is located at (X', Y') in the X-Y coordinate system of the signal state space for W'.

The soft-decision input value is represented by the square Euclidean distance 27 between the transmitted signal point 25 and the received signal point 26.

$$d^2(W',W)=(X'-X)^2+(Y'-Y)^2 \qquad (19)$$

Assuming an additive white Gaussian channel, the likelihood of the received signal point 26 occurring when the signal point 25 is transmitted is given by the following equation using the probability density function of two-dimensional normal distribution.

$$\Pr(W'|W) = \frac{1}{\sqrt{2\pi\sigma^2}}\exp\left\{\frac{d^2(W',W)}{2\sigma^2}\right\} \qquad (20)$$

The equation for calculating the log-likelihood ratio of the low-order information bit and the equation for calculating the log-likelihood ratio of the parity bit include a term for the likelihood $\Pr(W'|W)$. Each of the equations (4)-(7) includes a term that is logarithm of the equation (20). In calculating the log-likelihood ratio of the low-order information bit and the log-likelihood ratio of the parity bit according to the equations (4)-(7), the calculation can be simplified by simplifying the equation (20) as follows.

$$Pr(W'|W) \approx d'(W',W) \quad (21)$$

where d'(W', W) is represented as follows.

$$d'(W',W)=h'(w'_{1,k},w_{1,k}) \cdot d'x+h'(w'_{0,k},w_{0,k}) \cdot d'y \quad (22)$$

$$h'(w'_{1,k}, w_{1,k}) = \begin{cases} +1: h(w'_{1,k}) = w_{1,k} \\ -1: h(w'_{1,k}) \neq w_{1,k} \end{cases} \quad (23)$$

where $d'_x$ corresponds to the Euclidean distance 28 from the threshold value of Fig. 8(c), and $d'_y$ corresponds to the Euclidean distance 29 from the threshold value of Fig. 8(c).

By converting the square Euclidean distance 27 into the Euclidean distance 28, 29 from the threshold value of the signal constellation in the signal state space, the volume of calculation can be reduced without producing deterioration in the soft-decision input values.

According to the third embodiment, there is provided a method for reducing the volume of calculation needed in the decoders 32 and 38 for calculation of trellis branch metric, in addition to the method for reducing the volume of calculation in the soft-decision input value calculator 31.

Assuming the use of Log-MAP decoding in the decoders 32 and 38, the branch metric γ of trellis ($s_{j,k}$, $u_{2,k}$, $u_{1,k}$, $u_{0a,k}$) is calculated as follows.

$$\begin{aligned} &\gamma(S_{j,k}, u_{2,k}, u_{1,k}, u_{0a,k}) \\ &= Pr(W'_k, V'_k, S_{j,k}, u_{2,k}, u_{1,k}, u_{0a,k}) \\ &= \sum_{u_{0b,k}=0}^{1} Pr(W'_k | CS_{u_{0b,k}}) \cdot Pr(V'_k | CS_{u_{0b,k}}) \cdot Pr(u_{2,k}, u_{1,k}) \\ &\approx d'(W'_k, CS_{u_{0b,k}=0}) + d'(V'_k, CS_{u_{0b,k}=0}) \\ &\quad + d'(W'_k, CS_{u_{0b,k}=1}) + d'(V'_k, CS_{u_{0b,k}=1}) + L_a(u_{2,k}, u_{1,k}) \end{aligned} \quad (24)$$

where $CS_{u0b,k=0}$ indicates a coset for a case where $u_{2,k}$, $u_{1,k}$, $u_{0a,k}$ are fixed and $u_{0b,k}$=0.

Similarly, $CS_{u0b,k=1}$ indicates a coset for a case where $u_{2,k}$, $u_{1,k}$, $u_{0a,k}$ are fixed and $u_{0b,k}$=1.

Pr($W'_k$, $V'_k$, $S_{j,k}$, $u_{2,k}$, $u_{1,k}$, $u_{0a,k}$) indicates joint probability for a case where the low-order information bit is $u_{2,k}$, $u_{1,k}$, the transmitted parity bit is $u_{0a,k}$, the trellis status node is $S_{j,k}$ and the received signal points are $W'_k$, $V'_k$.

Pr($W'_k$|$CS_{u0b,k}$) indicates the likelihood that the received signal point $W'_k$ is received when the transmitted signal with the coset $CS_{u0b,k}$ is transmitted.

Pr($V'_k$|$CS_{u0b,k}$) indicates the likelihood that the received signal point $V'_k$ is received when the transmitted signal with the coset $CS_{u0b,k}$ is transmitted.

Pr($u_{2,k}$, $u_{1,k}$) indicates a priori probability of the low-order information bit $u_{2,k}$, $u_{1,k}$.

Using the equation (24), the branch metric can be calculated as a linear sum of the Euclidean distance between signal points and a priori probability.

Thus, according to the third embodiment, calculation with respect to the communication channel can be simplified. Further, calculation of the branch metric can be simplified. Accordingly, the circuit scale of the demodulating apparatus can be reduced.

Fourth embodiment

In the first through third embodiments, the use of the encoder of Figs. 2(a) and 2(b) is assumed. The first through third embodiments are assumed to be applied to an encoder where the conversion 2 is installed.

In the absence of the conversion 2, i.e., when the low-order information bit and the parity bit are as indicated by the equation (25), for example, the branch metric $\gamma$ is calculated as follows.

$$\begin{cases} w_{1,k} = u_{2,k} \\ w_{0,k} = u_{0a,k} \\ v_{1,k} = u_{1,k} \\ v_{0,k} = u_{0b,k} \end{cases} \qquad (25)$$

$$\begin{aligned} &\gamma(S_{j,k},u_{2,k},u_{1,k},u_{0a,k}) \\ &\approx h'(w'_{1,k},u_{2,k})\bullet d''(w_{1,k})+h'(v'_{1,k},u_{1,k})\bullet d''(v'_{1,k}) \\ &+h'(w'_{0,k},u_{0a,k})\bullet d''(w'_{0,k}) \\ &+\frac{1}{2}\{h'(1,u_{2,k})\bullet La(u_{2,k})+h'(1,u_{1,k})\bullet La(u_{1,k})\} \end{aligned} \qquad (26)$$

where $d''(w'_{1,k})$, $d''(v'_{1,k})$ each indicates the Euclidean distance 28 from the threshold value of Fig. 4(c) and $d''(w'_{0,k})$, $d''(v'_{0,k})$ each indicates the Euclidean distance 29. $L_a(u_{2,k})$, $L_a(u_{1,k})$ indicate a priori probability of the low-order information bit $u_{2,k}$, $u_{1,k}$, respectively.

The first through third embodiments are assumed to be applied to the multi-carrier demodulating method as shown in Fig. 2(c). However, the application is not limited to the method of Fig. 2(c).

While it is assumed in the above that the information bit and the parity bit according to the Turbo encoding is divided into two tones at a given point of time, as shown in Fig. 2(c), alternative arrangements are also possible.

It is assumed that the first through third embodiments are applied to the 16QAM demodulating method. The embodiments find applications in other methods of demodulation (for example, 256QAM) and still provide the same advantage.

INDUSTRIAL APPLICABILITY

As has been described, the demodulating method and apparatus according to the invention is suitably used in trellis coded demodulation using Turbo codes as element codes, for accurate estimation of high-order information bits and reduction in error in decoding high-order information bits

**Claims**

**1.** A demodulation method comprising:

a log-likelihood ratio calculation step for calculating soft-decision input values of Turbo decoding upon receipt of a sequence of received signal points, performing Turbo decoding using the soft-decision input values, and calculating a log-likelihood ratio of a low-order information bit and a log-likelihood ratio of a parity bit;
a coset estimation step for estimating the low-order information bit based on the log-likelihood ratio of the low-order information bit calculated by said log-likelihood ratio calculation step, estimating the parity bit based on the log-likelihood ratio of the parity bit calculated by said log-likelihood ratio calculation step, so as to estimate a coset based on the low-order information bit and the parity bit; and
high-order information bit estimation step for estimating a transmitted signal point based on the coset estimated by said coset estimation step, so as to estimate the high-order information bit based on the transmitted signal point.

**2.** The demodulation method according to claim 1, **characterized in that** said log-likelihood ratio calculation step calculates an Euclidean distance from a threshold value of a signal point constellation in a signal state space and uses the calculated distance as soft-decision input values of the Turbo decoding.

**3.** The demodulation method according to claim 2, **characterized in that** said log-likelihood ratio calculation step performs the Turbo decoding for calculating a branch metric of trellis using a linear sum of the soft-decision input values, so as to calculate the log-likelihood ratio of the low-order information bit and the log-likelihood ratio of the parity bit.

**4.** The demodulation method according to claim 1, **characterized in that** said log-likelihood ratio calculation step performs the Turbo decoding that includes conversion.

**5.** The demodulation method according to claim 1, **characterized in that** said log-likelihood ratio calculation step calculates an Euclidean distance from a threshold value of a signal point constellation in a signal state space so as to use the calculated distance as the soft-decision input values of the Turbo decoding that includes conversion, performs the Turbo decoding whereby a branch metric of trellis is calculated using a linear sum of the soft-decision input values, so as to calculate the log-likelihood ratio of the low-order information bit and the log-likelihood ratio of the parity bit.

**6.** A demodulation apparatus comprising:

log-likelihood ratio calculation means for calculating soft-decision input values of Turbo decoding upon receipt of a sequence of received signal points, performs Turbo decoding using the soft-decision input values, and calculating a log-likelihood ratio of a low-order information bit and a log-likelihood ratio of a parity bit;
a coset estimation means for estimating the low-order information bit based on the log-likelihood ratio of the low-order information bit calculated by said log-likelihood ratio calculation means, estimating the parity bit based on the log-likelihood ratio of the parity bit calculated by said log-likelihood ratio calculation means, so as to estimate a coset based on the low-order information bit and the parity bit; and
high-order information bit estimation means. for estimating a transmitted signal point based on the coset estimated by said coset estimation means so as to estimate a high-order information bit based on the transmitted signal point.

**7.** The demodulation apparatus according to claim 6, **characterized in that** said log-likelihood ratio calculation means calculates an Euclidean distance from a threshold value of a signal point constellation in a signal state space and uses the calculated distance as soft-decision input values of the Turbo decoding.

**8.** The demodulation apparatus according to claim 7, **characterized in that** said log-likelihood ratio calculation means performs the Turbo decoding for calculating a branch metric of trellis using a linear sum of the soft-decision input values, so as to calculate the log-likelihood ratio of the low-order information bit and the log-likelihood ratio of the parity bit.

**9.** The demodulation apparatus according to claim 6, **characterized in that** said log-likelihood ratio calculation means performs the Turbo decoding that includes conversion.

**10.** The demodulation apparatus according to claim 6, **characterized in that** said log-likelihood ratio calculation means calculates an Euclidean distance from a threshold value of a signal point constellation in a signal state space so as to use the calculated distance as the soft-decision input values of the Turbo decoding that includes conversion, performs the Turbo decoding whereby a branch metric of trellis is calculated using a linear sum of the soft-decision input values, so as to calculate the log-likelihood ratio of the low-order information bit and the log-likelihood ratio of the parity bit.

FIG.1

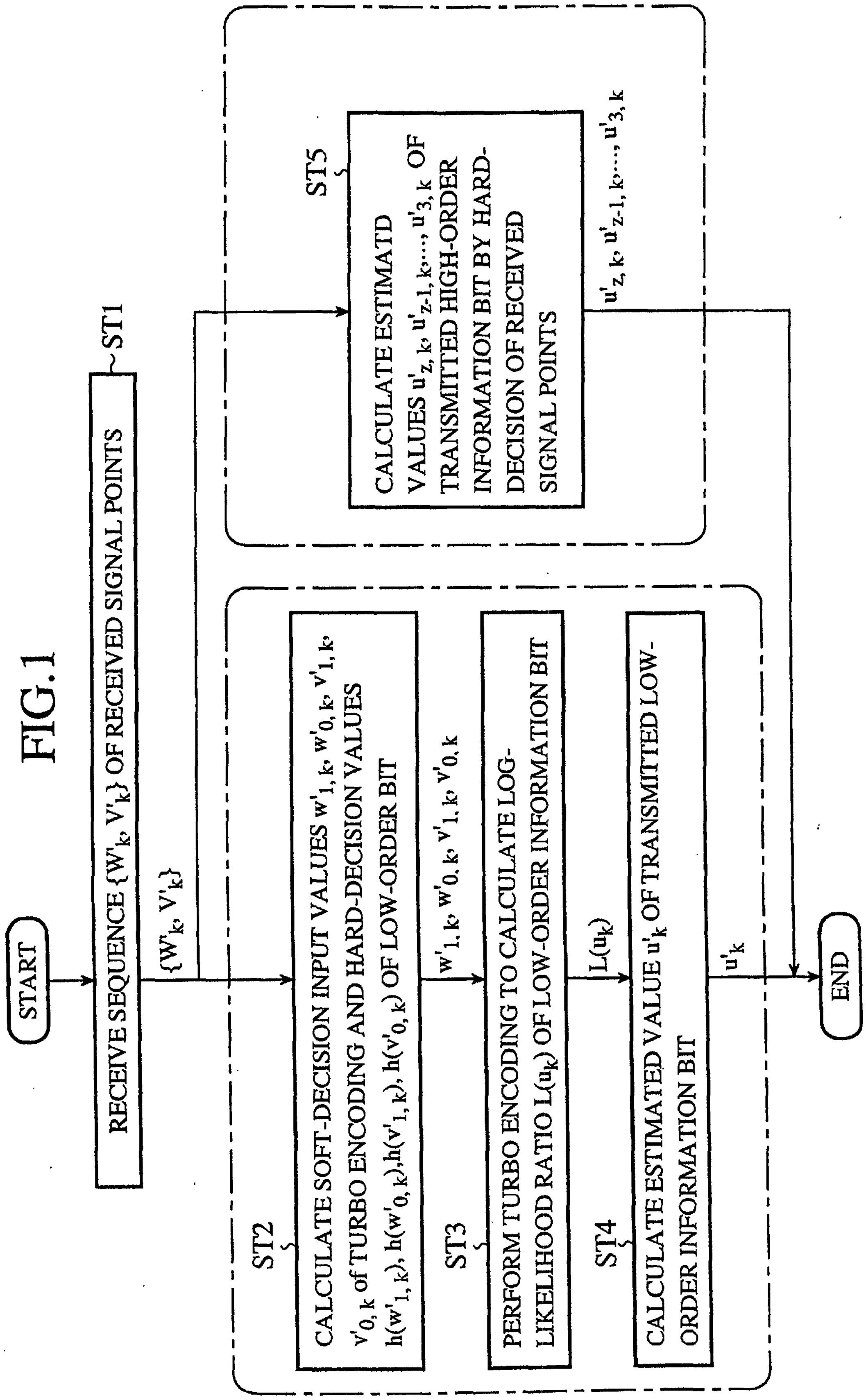
START
RECEIVE SEQUENCE {W'k, V'k} OF RECEIVED SIGNAL POINTS
ST1
{W'k, V'k}
ST2
CALCULATE SOFT-DECISION INPUT VALUES w'1, k, w'0, k, v'1, k, v'0, k of TURBO ENCODING AND HARD-DECISION VALUES h(w'1, k), h(w'0, k), h(v'1, k), h(v'0, k) OF LOW-ORDER BIT
w'1, k, w'0, k, v'1, k, v'0, k
ST3
PERFORM TURBO ENCODING TO CALCULATE LOG-LIKELIHOOD RATIO L(uk) OF LOW-ORDER INFORMATION BIT
L(uk)
ST4
CALCULATE ESTIMATED VALUE u'k OF TRANSMITTED LOW-ORDER INFORMATION BIT
u'k
ST5
CALCULATE ESTIMATD VALUES u'z, k, u'z-1, k,..., u'3, k OF TRANSMITTED HIGH-ORDER INFORMATION BIT BY HARD-DECISION OF RECEIVED SIGNAL POINTS
u'z, k, u'z-1, k,..., u'3, k
END

# FIG.2

(a)

(b)

(c)

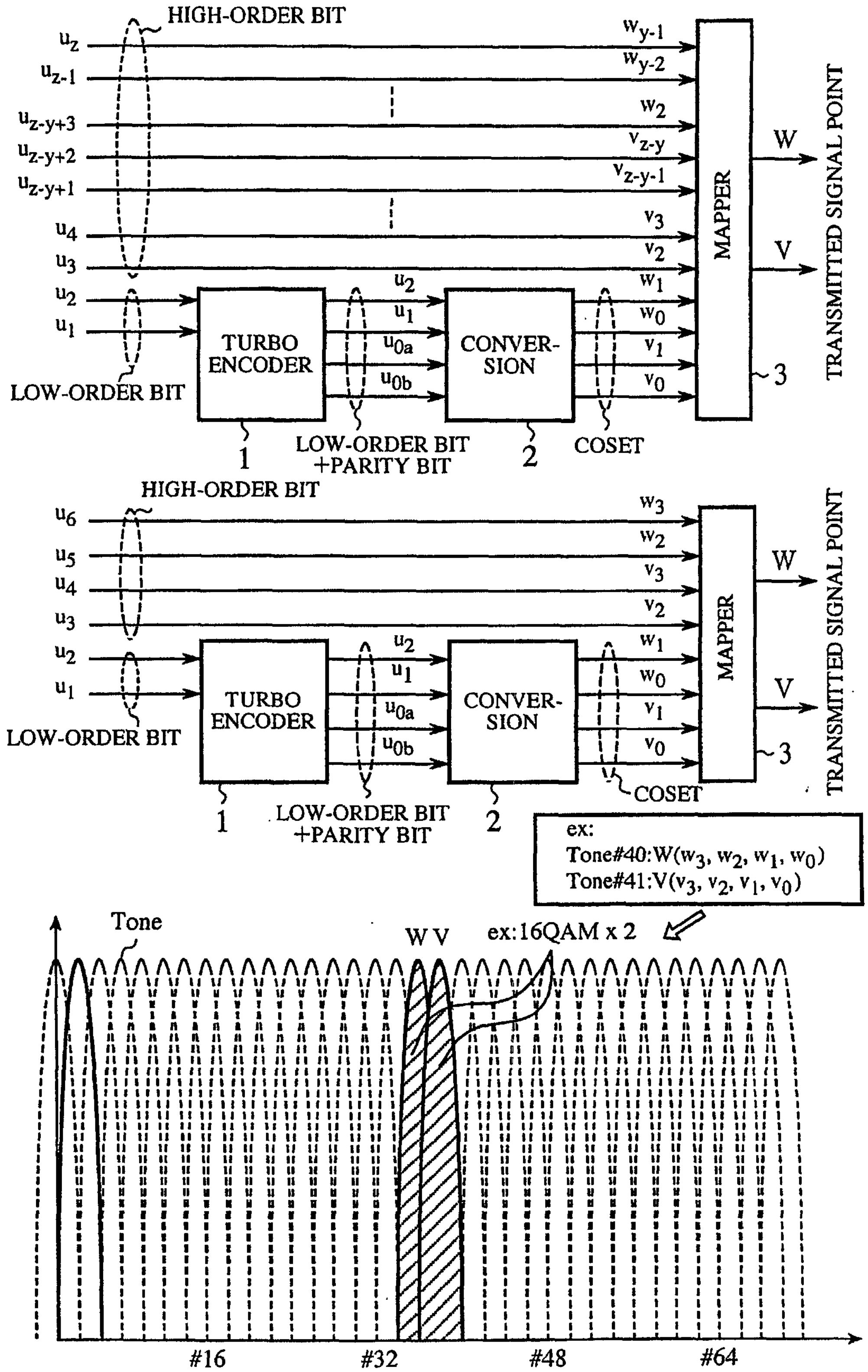
HIGH-ORDER BIT
$u_z$
$u_{z-1}$
$u_{z-y+3}$
$u_{z-y+2}$
$u_{z-y+1}$
$u_4$
$u_3$
$u_2$
$u_1$
LOW-ORDER BIT
TURBO ENCODER
1
$u_2$ $u_1$ $u_{0a}$ $u_{0b}$
LOW-ORDER BIT +PARITY BIT
CONVER-SION
2
COSET
$w_{y-1}$ $w_{y-2}$ $w_2$ $v_{z-y}$ $v_{z-y-1}$ $v_3$ $v_2$ $w_1$ $w_0$ $v_1$ $v_0$
MAPPER
3
W
V
TRANSMITTED SIGNAL POINT
HIGH-ORDER BIT
$u_6$ $u_5$ $u_4$ $u_3$ $u_2$ $u_1$
LOW-ORDER BIT
TURBO ENCODER
1
$u_2$ $u_1$ $u_{0a}$ $u_{0b}$
LOW-ORDER BIT +PARITY BIT
CONVER-SION
2
COSET
$w_3$ $w_2$ $v_3$ $v_2$ $w_1$ $w_0$ $v_1$ $v_0$
MAPPER
3
W
V
TRANSMITTED SIGNAL POINT
ex:
Tone#40:W($w_3$, $w_2$, $w_1$, $w_0$)
Tone#41:V($v_3$, $v_2$, $v_1$, $v_0$)
Tone
W V
ex:16QAM x 2
#16
#32
#48
#64

FIG.3

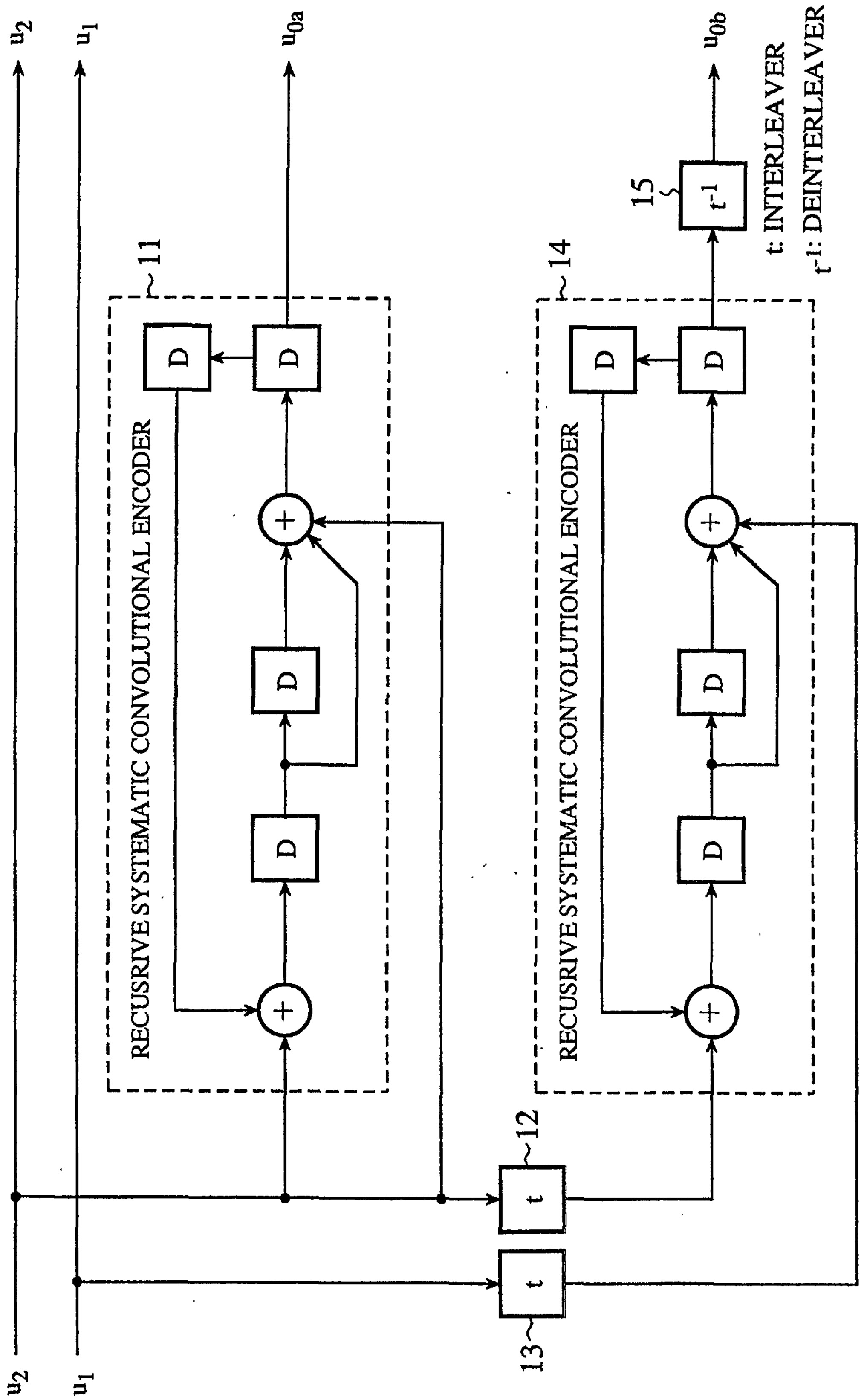
u2
u1
u0a
u0b
11
RECUSRIVE SYSTEMATIC CONVOLUTIONAL ENCODER
D
D
D
D
14
RECUSRIVE SYSTEMATIC CONVOLUTIONAL ENCODER
D
D
D
D
15
t-1
12
t
13
t
t: INTERLEAVER
t-1: DEINTERLEAVER
u2
u1

# FIG.4

(a)

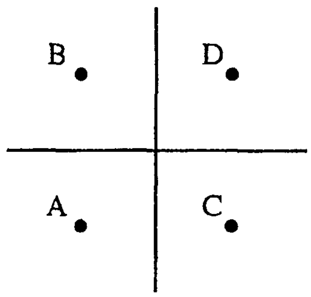


(b)

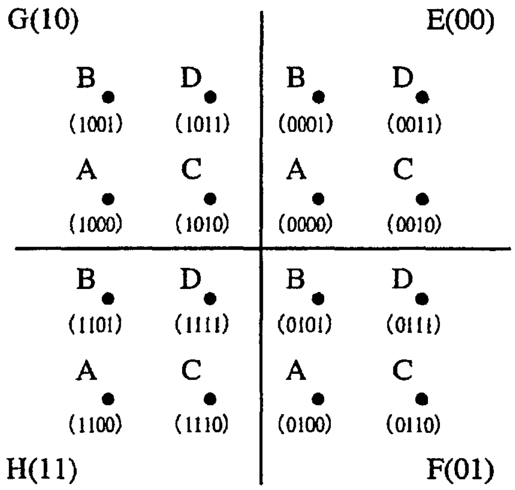


(c)

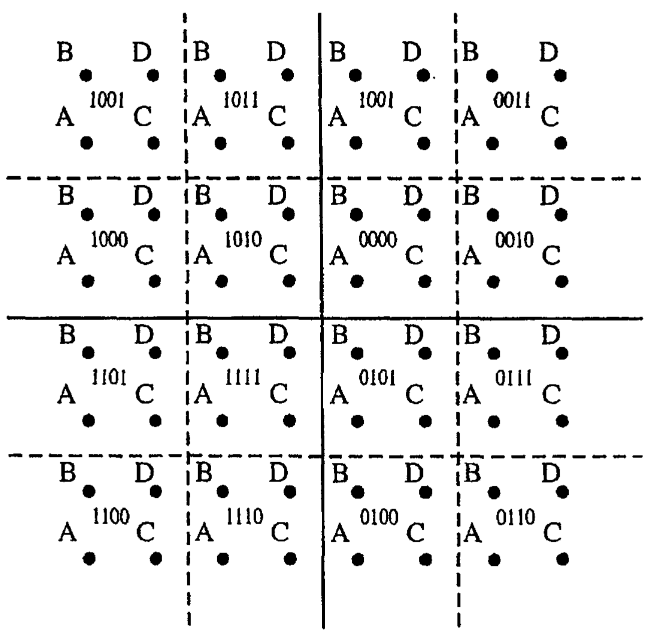


(d)

| COSET | $w_1$ | $w_0$ |
|---|---|---|
| A | 0 | 0 |
| B | 0 | 1 |
| C | 1 | 0 |
| D | 1 | 1 |

(e)

| AREA | $w_3$ | $w_2$ |
|---|---|---|
| E | 0 | 0 |
| F | 0 | 1 |
| G | 1 | 0 |
| H | 1 | 1 |

FIG.5

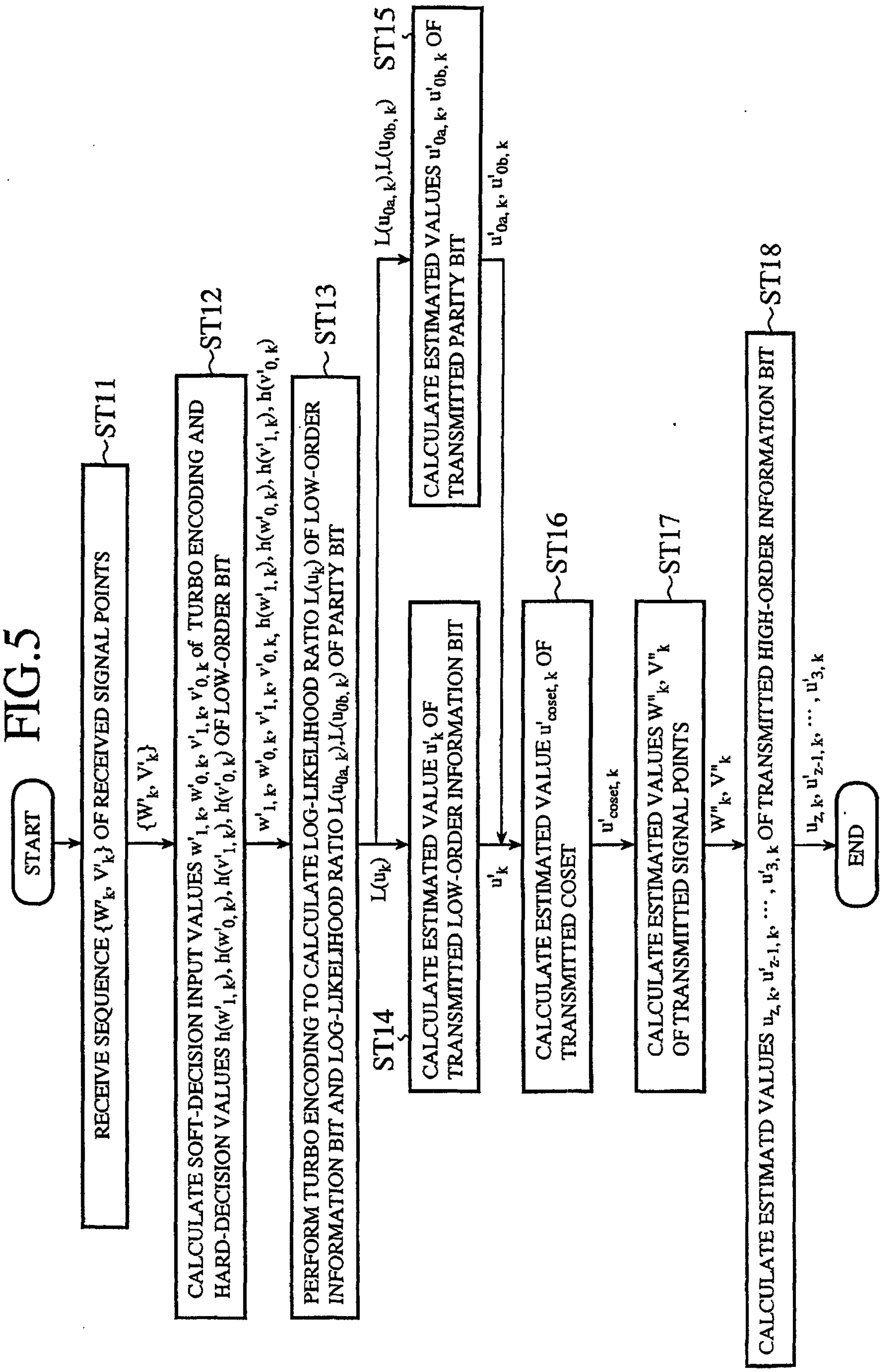
START
RECEIVE SEQUENCE $\{W'_k, V'_k\}$ OF RECEIVED SIGNAL POINTS
ST11
$\{W'_k, V'_k\}$
CALCULATE SOFT-DECISION INPUT VALUES $w'_{1,k}, w'_{0,k}, v'_{1,k}, v'_{0,k}$ of TURBO ENCODING AND HARD-DECISION VALUES $h(w'_{1,k}), h(w'_{0,k}), h(v'_{1,k}), h(v'_{0,k})$ OF LOW-ORDER BIT
ST12
$w'_{1,k}, w'_{0,k}, v'_{1,k}, v'_{0,k}, h(w'_{1,k}), h(w'_{0,k}), h(v'_{1,k}), h(v'_{0,k})$
PERFORM TURBO ENCODING TO CALCULATE LOG-LIKELIHOOD RATIO $L(u_k)$ OF LOW-ORDER INFORMATION BIT AND LOG-LIKELIHOOD RATIO $L(u_{0a,k}), L(u_{0b,k})$ OF PARITY BIT
ST13
$L(u_k)$
$L(u_{0a,k}), L(u_{0b,k})$
ST14
CALCULATE ESTIMATED VALUE $u'_k$ OF TRANSMITTED LOW-ORDER INFORMATION BIT
ST15
CALCULATE ESTIMATED VALUES $u'_{0a,k}, u'_{0b,k}$ OF TRANSMITTED PARITY BIT
$u'_{0a,k}, u'_{0b,k}$
$u'_k$
CALCULATE ESTIMATED VALUE $u'_{coset,k}$ OF TRANSMITTED COSET
ST16
$u'_{coset,k}$
CALCULATE ESTIMATED VALUES $W''_k, V''_k$ OF TRANSMITTED SIGNAL POINTS
ST17
$W''_k, V''_k$
CALCULATE ESTIMATD VALUES $u_{z,k}, u'_{z-1,k}, \cdots, u'_{3,k}$ OF TRANSMITTED HIGH-ORDER INFORMATION BIT
ST18
$u_{z,k}, u'_{z-1,k}, \cdots, u'_{3,k}$
END

FIG.6

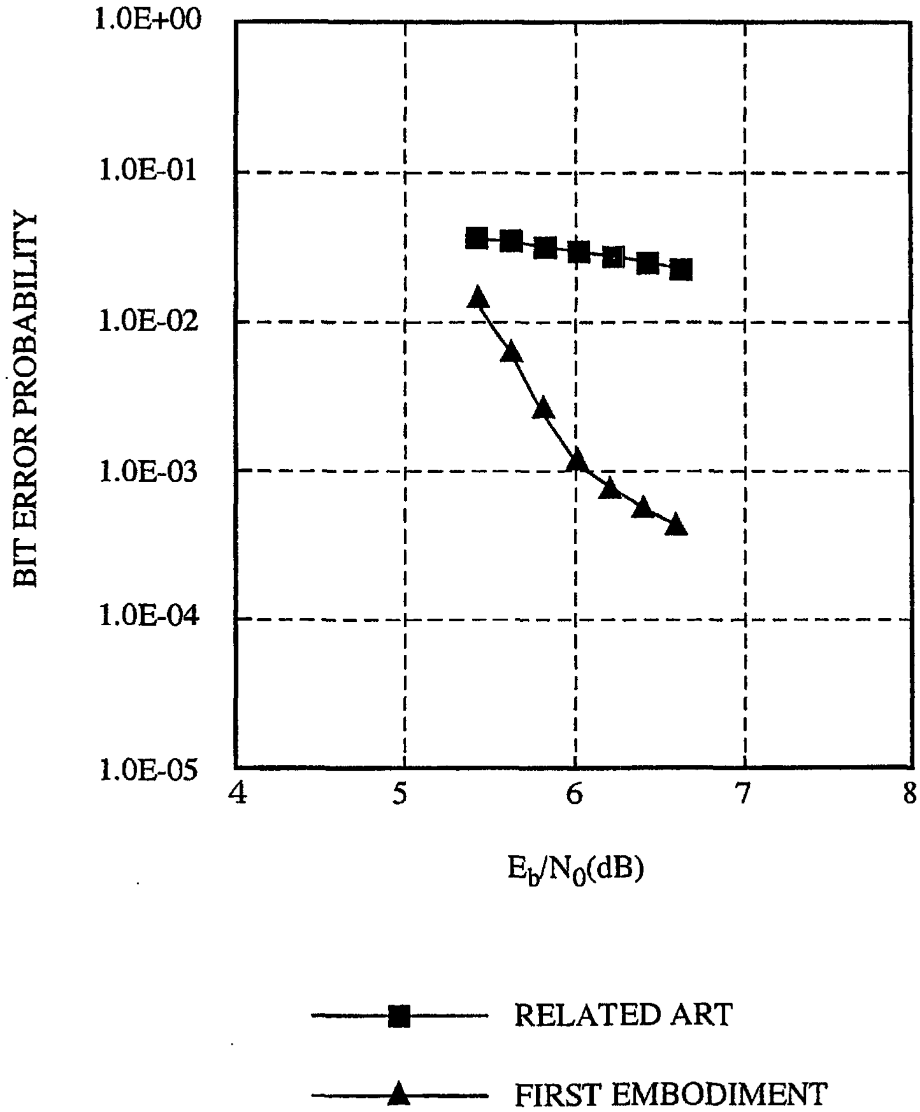
1.0E+00
1.0E-01
1.0E-02
1.0E-03
1.0E-04
1.0E-05
BIT ERROR PROBABILITY
4
5
6
7
8
Eb/N0(dB)
RELATED ART
FIRST EMBODIMENT

FIG.7

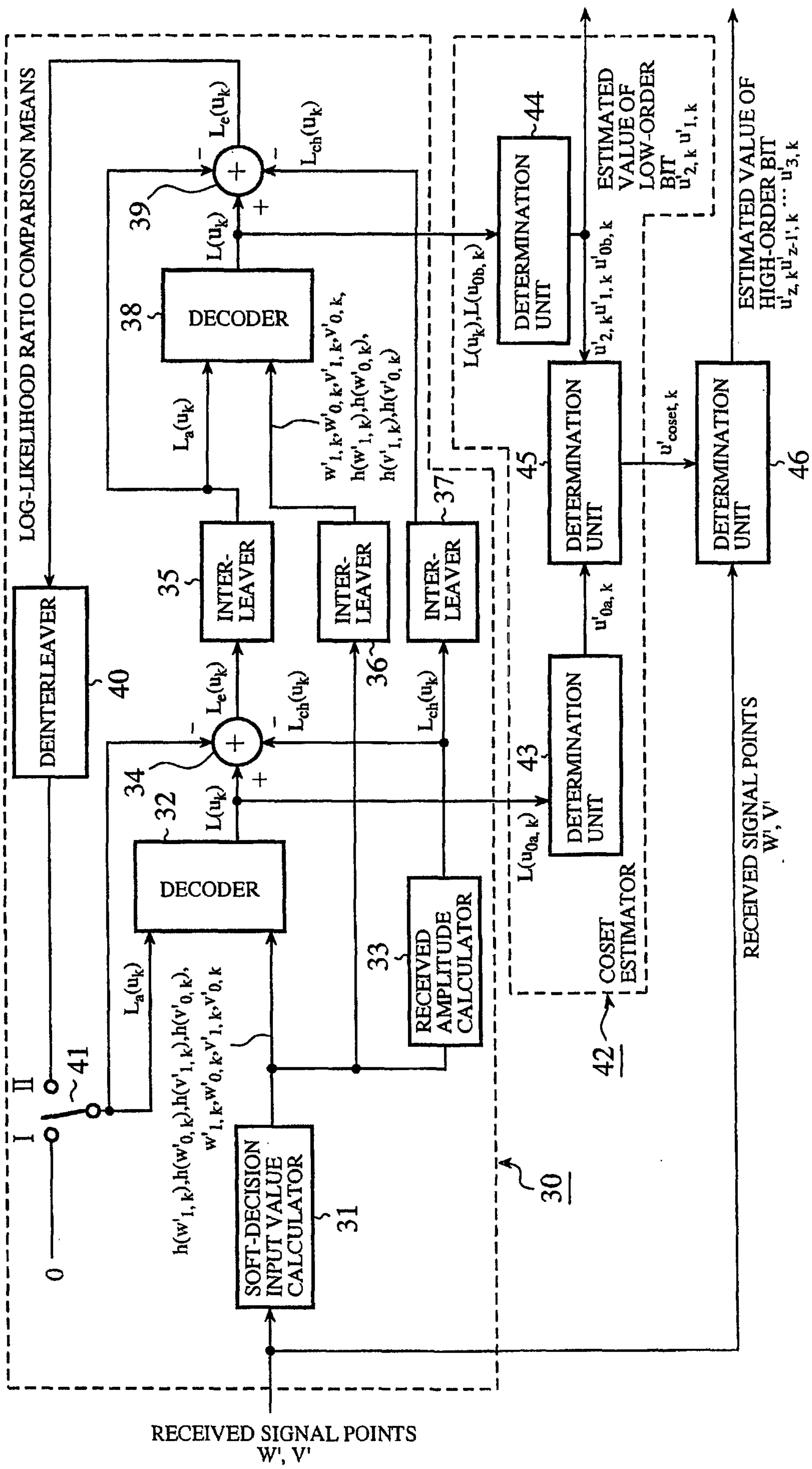
LOG-LIKELIHOOD RATIO COMPARISON MEANS
DEINTERLEAVER
40
0
I
II
41
$L_a(u_k)$
SOFT-DECISION INPUT VALUE CALCULATOR
31
$h(w'_{1,k}),h(w'_{0,k}),h(v'_{1,k}),h(v'_{0,k}),$
$w'_{1,k},w'_{0,k},v'_{1,k},v'_{0,k}$
DECODER
32
$L(u_k)$
34
$L_e(u_k)$
$L_{ch}(u_k)$
RECEIVED AMPLITUDE CALCULATOR
33
INTER-LEAVER
35
36
37
DECODER
38
$L_a(u_k)$
$w'_{1,k},w'_{0,k},v'_{1,k},v'_{0,k},$
$h(w'_{1,k}),h(w'_{0,k}),$
$h(v'_{1,k}),h(v'_{0,k})$
$L(u_k)$
39
$L_e(u_k)$
$L_{ch}(u_k)$
30
DETERMINATION UNIT
43
$L(u_{0a,k})$
$u'_{0a,k}$
DETERMINATION UNIT
44
$L(u_k),L(u_{0b,k})$
ESTIMATED VALUE OF LOW-ORDER BIT
$u'_{2,k}\ u'_{1,k}$
$u'_{2,k}u'_{1,k}\ u'_{0b,k}$
DETERMINATION UNIT
45
$u'_{coset,k}$
DETERMINATION UNIT
46
COSET ESTIMATOR
42
ESTIMATED VALUE OF HIGH-ORDER BIT
$u'_{z,k}u'_{z-1',k}\cdots u'_{3,k}$
RECEIVED SIGNAL POINTS
W', V'
RECEIVED SIGNAL POINTS
W', V'

FIG.8

(a)

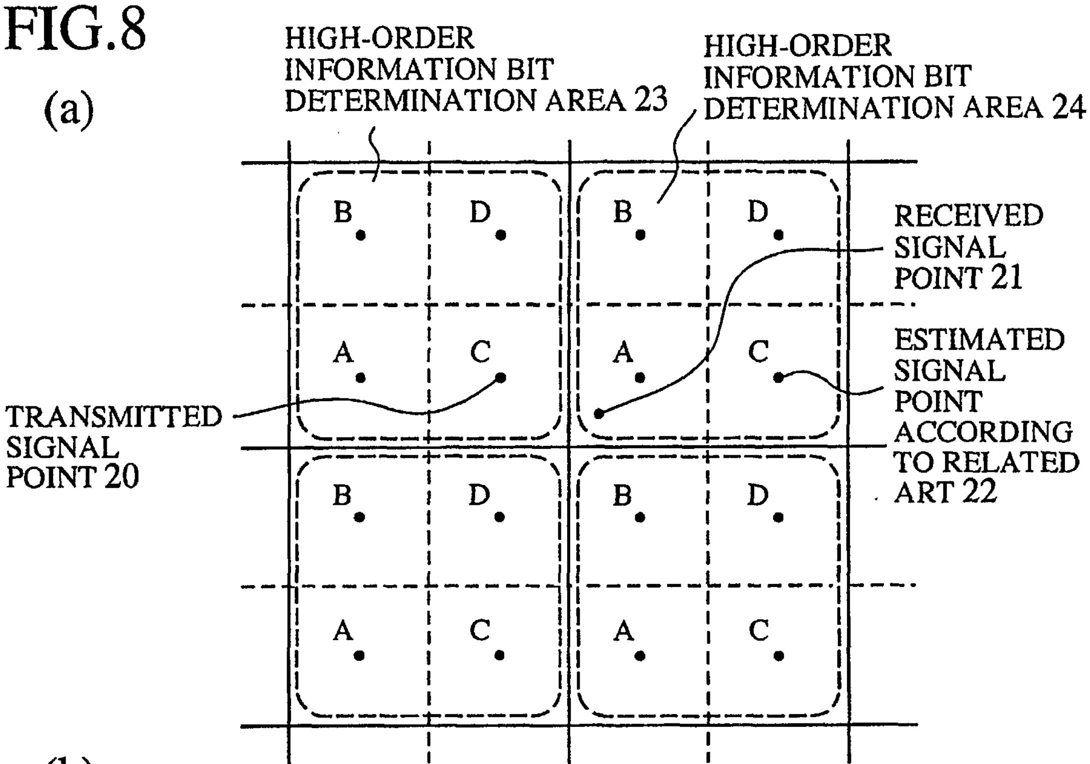


(b)

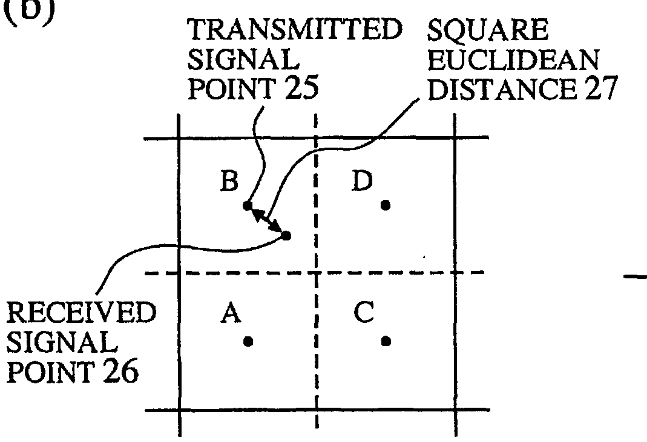


(c)

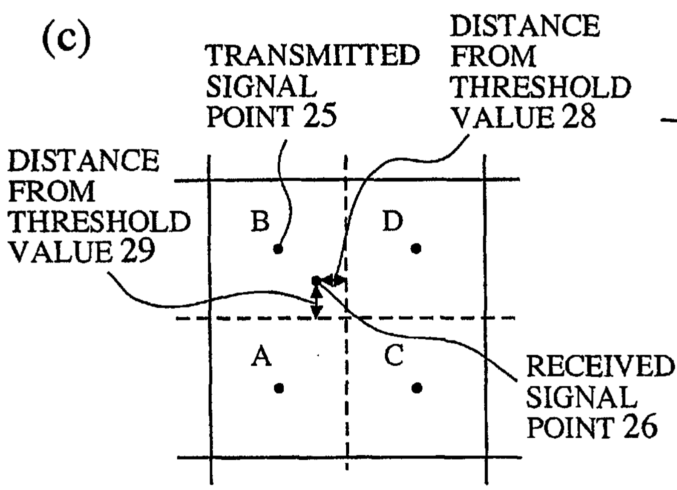


(d)

| COSET | $h(w'_{1,k})$ | $h(w'_{0,k})$ |
|---|---|---|
| A | 0 | 0 |
| B | 0 | 1 |
| C | 1 | 0 |
| D | 1 | 1 |

| COSET | $h(v'_{1,k})$ | $h(v'_{0,k})$ |
|---|---|---|
| A | 0 | 0 |
| B | 0 | 1 |
| C | 1 | 0 |
| D | 1 | 1 |

# INTERNATIONAL SEARCH REPORT

International application No.
PCT/JP01/01919

**A. CLASSIFICATION OF SUBJECT MATTER**

Int.Cl[7] H03M13/25, 13/27, 13/45
H04J11/00, H04L27/00

According to International Patent Classification (IPC) or to both national classification and IPC

**B. FIELDS SEARCHED**

Minimum documentation searched (classification system followed by classification symbols)

Int.Cl[7] H03M13/25, 13/27, 13/45
H04J11/00, H04L27/00

Documentation searched other than minimum documentation to the extent that such documents are included in the fields searched

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| E,A | JP, 2001-127649, A (Mitsubishi Electric Corporation), 11 May, 2001 (11.05.01), Fig. 1 (Family: none) | 1-10 |
| A | FR, 2756996, A (PHILIPS ELECTRONICS NV), 12 June, 1998 (12.06.98) & EP, 848501, A1 & JP, 11-4270, A & US, 6038696, A | 1-10 |

☐ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 23 May, 2001 (23.05.01) | 05 June, 2001 (05.06.01) |
| Name and mailing address of the ISA/ Japanese Patent Office | Authorized officer |
| Facsimile No. | Telephone No. |

Form PCT/ISA/210 (second sheet) (July 1992)